# EUROPÄISCHE PATENTSCHRIFT

(11) **EP 3 798 653 B1**
(45) Veröffentlichungstag und Bekanntmachung des Hinweises auf die Patenterteilung: **23.08.2023**
(21) Anmeldenummer: 20194956.7
(22) Anmeldetag: 08.09.2020
(51) Int. Cl.: G01R 31/52, G01R 27/02, H02H 3/17, B60L 3/00

(54) **KOMBINIERTE ÜBERWACHUNGSVORRICHTUNG ZUR ISOLATIONSWIDERSTANDS- UND SCHUTZLEITERWIDERSTANDS-ÜBERWACHUNG EINES STROMVERSORGUNGSSYSTEMS**
COMBINED MONITORING DEVICE FOR MONITORING THE INSULATION RESISTANCE AND LIMITING CIRCUIT RESISTANCE OF A POWER SUPPLY SYSTEM
DISPOSITIF DE SURVEILLANCE COMBINÉ POUR LA SURVEILLANCE DE LA RÉSISTANCE D'ISOLATION ET LA RÉSISTANCE DU CONDUCTEUR DE PROTECTION D'UN SYSTÈME D'ALIMENTATION ÉLECTRIQUE

(30) Priorität: 26.09.2019 DE 102019125982
(43) Veröffentlichungstag der Anmeldung: 31.03.2021
(73) Patentinhaber: Bender GmbH & Co. KG, 35305 Grünberg (DE)
(72) Erfinder: ERK, Julian, 63691 Ranstadt (DE); KAMMER, Michael, 35410 Hungen (DE); MÖLL, Winfried, 35321 Laubach (DE)
(74) Vertreter: advotec.

(56) Entgegenhaltungen:
- DE-A1-102009 001 962
- DE-A1-102011 084 362

## Beschreibung

Die Erfindung betrifft eine kombinierte Überwachungsvorrichtung zur Isolationswiderstands- und Schutzleiterwiderstands-Überwachung in einem Stromversorgungssystem, welches ein geerdetes Stromversorgungssystem und ein ungeerdetes Stromversorgungssystem umfasst.

Für den Betrieb von elektrischen Verbrauchern und Betriebsmitteln (im Folgenden wird die Bezeichnung Verbraucher übergeordnet für elektrische Verbraucher und Betriebsmittel verwendet) sind geeignete Schutzmaßnahmen zum Schutz vor elektrischem Schlag - wie beispielsweise in der internationalen Norm IEC 61140 festgelegt - zu treffen.

So sind bei einem mit einem aufladbaren Energiespeicher (Akkumulator/Batterie oder Kondensator) und mit gefährlich hohen Systemspannungen betriebenen Verbraucher Schutzmaßnahmen einerseits während des Betriebes des Verbrauchers in einem ungeerdeten Netzzustand und andererseits in einem geerdeten Netzzustand erforderlich.

Während des Betriebes in dem ungeerdeten Netzzustand, beispielsweise dem Fahrbetrieb eines Elektrofahrzeugs, besteht keine galvanische Verbindung zu einer externen Stromversorgung und die im Betrieb befindliche elektrische Anlage, beispielsweise das Bordnetz (Batterienetz) eines Elektrofahrzeugs, kann als (ortsveränderliches) ungeerdetes Stromversorgungssystem mit dem aufgeladenen Energiespeicher als Stromversorgung betrachtet werden.

Für jedes ungeerdete elektrische Stromversorgungssystem ist eine geeignete Isolationsüberwachung nach der Norm IEC 61557-8 als Schutzmaßnahme erforderlich. Gemäß dieser Norm ist ein Isolationsüberwachungsgerät (Insulation Monitoring Device - IMD) vorgeschrieben, das den Isolationswiderstand - den Widerstand des zu überwachenden Netzes einschließlich der Widerstände aller daran angeschlossenen Verbraucher gegen Erde - kontinuierlich überwacht.

Beispielsweise erfolgt im Fahrbetrieb des Elektrofahrzeugs die Isolationswiderstands-Überwachung durch ein in dem Elektrofahrzeug verbautes Isolationsüberwachungsgerät.

Die Isolationsüberwachung eines Stromversorgungssystems kann entweder nach einem aktiven oder passiven Messverfahren arbeiten.

Bei dem hier betrachteten aktiven Messverfahren mit einer Überwachungseinrichtung in der Funktion als aktives Isolationsüberwachungsgerät wird eine Messspannung (Messsignal) in das zu überwachende Netz eingeprägt. Der durch die Messspannung bewirkte Messstrom fließt - beispielsweise in einem Gleichstromnetz - über die Einzel-Isolationswiderstände Rf+ und Rf- und wird über eine Erdverbindung - in der Regel der Schutzleiter oder im Beispiel eines Elektrofahrzeugs die Fahrzeugkarosserie - zurückgeführt und in dem Isolationsüberwachungsgerät ausgewertet. Unterschreitet der aus dem zurückgemessenen Messstrom errechnete Isolationswiderstand einen anlagenspezifisch festgelegten Isolationswiderstands-Grenzwert (Ansprechwert) wird ein Alarmsignal ausgelöst. Dadurch können im Gegensatz zu dem passiven Messverfahren, bei dem keine Einspeisung eines separat erzeugten Messsignals erfolgt, auch symmetrische Isolationsfehler erkannt werden.

Während des Betriebs im geerdeten Netzzustand, beispielsweise im Ladebetrieb, ist der Verbraucher galvanisch mit dem geerdeten Stromversorgungssystem verbunden. Für diese Netzform des geerdeten Netzes ist durch die Norm IEC 60364-41-1 als Schutzmaßnahme vor elektrischem Schlag ein wirksamer Schutzleiter (PE-Leiter) zu installieren, der alle leitfähigen berührbaren Teile an das Erdungssystem des geerdeten Stromversorgungssystems anschließt.

Die Schutzleiterverbindung ist dabei hinsichtlich ihrer Durchgängigkeit kontinuierlich zu überwachen. Tritt während des Betriebs in geerdetem Netzzustand ein Isolationsfehler auf, wird der daraus resultierende Fehlerstrom über den Schutzleiter abgeleitet und eine gefährlich hohe Berührungsspannung vermieden. Voraussetzung dafür ist, dass der Schutzleiter ausreichend niederohmig mit dem Erdungssystem des speisenden Stromversorgungsystems verbunden ist. Um die ausreichende Niederohmigkeit sicherzustellen, kann der Schutzleiter durch eine geeignete Schutzleiterwiderstands- bzw. Schutzleiterimpedanzmessung überwacht werden, wobei der Widerstand/die Impedanz über einen zentralen Erdungspunkt und einen aktiven Leiter (Außenleiter oder Neutralleiter) des geerdeten Stromversorgungssystems gemessen wird. Die Schutzleiterwiderstands- bzw. Schutzleiterimpedanzmessung umfasst zielgerichtet auch die aktiven Leiter als Rückleiter. Dabei kann davon ausgegangen werden, dass die aktiven Leiter niederohmig sind. Im Folgenden ist daher bei der Verwendung des Begriffs PE-Widerstand oder Schutzleiter-Widerstand der komplette Schleifenwiderstand zu verstehen.

Aus dem Stand der Technik ist es bekannt, die beiden sicherheitsrelevanten Netzgrößen Isolations- und Schutzleiterwiderstand mit getrennten, unabhängig voneinander arbeitenden Überwachungseinrichtungen zu überwachen.

So ist beispielsweise auf dem Anwendungsgebiet der Elektromobilität in der Norm IEC 61851-1 vorgeschrieben, während der Aufladung des Energiespeichers des Elektrofahrzeugs zur Schutzleiterüberwachung einen zusätzlichen Signalkontakt CP (Control Pilot bzw. Pilotkontakt) als Hilfsleiter zu verwenden. Dabei erfolgt jedoch in nachteiliger Weise keine Aussage über die Güte der Schutzleiterverbindung, also über den - möglichst geringen - elektrischen Widerstand des PE-Leiters.

Die Offenlegungsschrift DE 10 2009 001962 A1 zeigt ein Ladesystem für ein Elektrofahrzeug mit einem Fahrzeughochvoltnetz, wobei das Ladesystem neben einem FI-Schutzschalter zur Fehlerstromüberwachung insbesondere Mittel zur permanenten Schutzleiterfunktionsüberwachung während des Ladevorgangs sowie Mittel zur Isolationsüberwachung des Fahrzeughochvoltnetzes und des Ladegerätes vor dem Start des Ladevorgangs aufweist.

Weiterhin zeigt die Offenlegungsschrift DE 10 2011 084362 A1 Vorrichtungen und Verfahren zum sicheren Fahr-, Lade- und Rückspeisebetrieb eines Elektrofahrzeugs. Dabei ist ein Isolationsüberwachungsgerät und ein Differenzstromüberwachungsgerät in einer baulichen Einheit integriert als Kombiüberwachungsgerät in dem Fahrzeug ausgeführt, wobei das gesamte aus Elektrofahrzeug, Ladestation und Ladekabel bestehende Ladesystem überwacht und im Fahrbetrieb die Differenzstromüberwachung deaktiviert ist.

Die aus dem Stand der Technik bekannten Lösungen weisen den Nachteil auf, dass für die Isolations- und die Schutzleiter-Überwachung jeweils getrennte, unabhängig voneinander arbeitende Überwachungseinrichtungen erforderlich sind. Damit verbunden sind hohe Produktions- und Installationskosten sowie ein erhöhter Platzbedarf. Insbesondere für Anwendungsbereiche der Elektromobilität müssen auch die bei der Schutzleiter-Überwachung normativ vorgeschriebenen erforderlichen Signalkontakte bei der Anbindung des Verbrauchers an das Stromversorgungssystem vorgesehen werden.

Der vorliegenden Erfindung liegt daher die Aufgabe zugrunde, eine Überwachungsvorrichtung zu konzipieren, die sowohl die Überwachung des Schutzleiterwiderstands eines geerdeten Stromversorgungssystems als auch die Überwachung des Isolationswiderstands eines ungeerdeten Stromversorgungssystems hinsichtlich Kosten, Energieverbrauch, Bauraum und Gewicht in effizienter Weise ermöglicht.

Diese Aufgabe wird erfindungsgemäß durch eine kombinierte Überwachungsvorrichtung zur Isolationswiderstands- und Schutzleiterwiderstands-Überwachung mit den Merkmalen nach Anspruch 1 gelöst.

Die Ausgestaltung nach Anspruch 1 beschreibt eine erste Ausführungsform (Grundausführung), deren Merkmale auch von der zweiten und dritten Ausführungsform umfasst sind.

Der Erfindung liegt die Erkenntnis zugrunde, dass bei beiden Überwachungsaufgaben - einerseits der Isolationsüberwachung während der Trennung des Verbrauchers von dem versorgenden, geerdeten Stromversorgungssystem (ungeerdeter Netzzustand/Betrieb - beispielsweise im Fahrbetrieb des Elektrofahrzeugs) und andererseits der Schutzleiterüberwachung während der Anbindung an das geerdete Stromversorgungssystem (geerdeter Netzzustand/Betrieb - beispielsweise während des Ladevorgangs) - das anzuwendende Überwachungsverfahren zwischen die aktiven Leiter des jeweiligen Stromversorgungssystems und dem Schutzleitersystem/Erde/Karosserie geschaltet wird. In beiden Betriebsfällen kann der Widerstand durch die Einprägung einer Messspannung ermittelt werden: im ungeerdeten Betrieb ist der zu ermittelnde Widerstand der Isolationswiderstand, im geerdeten Betrieb der Schutzleiterwiderstand.

Nach dem Stand der Technik ist es erforderlich, das in dem ungeerdeten Stromversorgungssystem, beispielsweise in dem Batterienetz des Elektrofahrzeugs, verbaute Isolationsüberwachungsgerät abzuschalten, wenn dieses Netz galvanisch mit einem geerdeten Stromversorgungsnetz verbunden wird. Ansonsten würde das Isolationsüberwachungsgerät auslösen, da durch die Verbindung des ungeerdeten mit dem geerdeten Netz - beispielsweise durch das Einstecken eines Ladekabels - das ungeerdete Netz zu einem geerdeten Netz und der gemessene Isolationswiderstand sich zu Null ergeben würde.

Da das verbaute Isolationsüberwachungsgerät im geerdeten Betrieb demnach für die Ermittlung des Isolationswiderstands außer Funktion ist, kann dieses erfindungsgemäß als aktive Überwachungseinrichtung während des geerdeten Betriebs zur Überwachung der Durchgängigkeit (Niederohmigkeit) des Schutzleiters eingesetzt werden.

Aus diesen Überlegungen ergibt sich als Gegenstand der Erfindung eine kombinierte Überwachungsvorrichtung, die dem zu überwachenden Netz entsprechend, also an die Netzform geerdet/ungeerdet angepasst, auf die erforderliche Schutzfunktion - entweder die Isolationswiderstands- oder die Schutzleiterwiderstands-Überwachung - umschaltet oder umgeschaltet wird und somit funktionsübergreifend im geerdeten wie im ungeerdeten Betrieb, beispielsweise im Lade- und im operativen Fahrbetrieb, den Schutz vor elektrischem Schlag sicherstellt.

Die kombinierte Überwachungsvorrichtung verfügt dazu über eine Ankopplungsschaltung zur Ankopplung an einen oder mehrere aktive Leiter des geerdeten Stromversorgungssystems über Ankopplungspunkte sowie über eine aktive Überwachungseinrichtung.

Die aktive Überwachungseinrichtung weist einen ersten Betriebsmodus zur Überwachung eines Isolationswiderstands in einem ungeerdeten Netzzustand des Stromversorgungssystems und einen zweiten Betriebsmodus zur Überwachung eines Schutzleiterwiderstands in einem geerdeten Netzzustand des Stromversorgungssystems auf und umfasst eine in Abhängigkeit des ungeerdeten oder geerdeten Netzzustands zwischen dem ersten Betriebsmodus und dem zweiten Betriebsmodus umschaltbare Auswerteeinheit, die in dem ersten Betriebsmodus zur Prüfung des Isolationswiderstands und in dem zweiten Betriebsmodus zur Prüfung des Schutzleiterwiderstands ausgeführt ist.

Durch die Kombination beider Anwendungen in einer kombinierten Überwachungsvorrichtung bzw. der Mehrfachverwendung eines diese kombinierte Überwachungsvorrichtung realisierenden Gerätes können in vorteilhafter Weise Kosten, Energieverbrauch und Gewicht reduziert und die Anforderungen an den Bauraum gesenkt werden. Wo bislang noch zwei getrennte, unabhängig voneinander arbeitende Überwachungseinrichtungen erforderlich sind, können die Erfordernisse an die elektrische Sicherheit mit nur einem (Kombi-)Gerät erfüllt werden.

Diese Faktoren spielen beispielsweise im Automobilbereich eine immer größer werdende Rolle. Durch die kombinierte Überwachungsvorrichtung kann ein weiter Marktbereich bedient und gegebenenfalls ein Wettbewerbsvorteil generiert werden.

Mit Blick auf die Elektromobilität ergibt sich als weiterer Vorteil, dass keine zusätzlichen Signalkontakte zur Überwachung des Schutzleiterwiderstandes notwendig sind. Somit kann das Elektrofahrzeug neben Ladestationen und -boxen auch an nahezu allen gängigen Stromanschlüssen aufgeladen werden.

Bei der Anwendung der kombinierten Überwachungsvorrichtung ist es unerheblich, ob es sich dabei um ein beliebiges geerdetes Stromversorgungsnetz nach IEC-Norm (50Hz: AC 230V; 3AC 400V; 3NAC 400V/230V) oder UL-Standard (60Hz: AC 120V 2AC 240V) handelt.

Die erfindungsgemäße kombinierte Überwachungsvorrichtung ist dabei grundsätzlich in allen Anwendungsumgebungen einsetzbar, in denen eine gezielte Umschaltung zwischen ungeerdetem Netz und geerdetem Netz erfolgen kann. Dies kann prinzipiell in allen denkbaren ungeerdeten Stromversorgungssystemen, wie beispielsweise unterbrechungsfreien Stromversorgungen, Inselnetzen oder im Bereich der Elektromobilität, geschehen.

In weiterer Ausgestaltung weist die aktive Überwachungseinrichtung einen Umschaltsignal-Eingang zur Umschaltung zwischen dem ersten Betriebsmodus und dem zweiten Betriebsmodus mittels eines externen Umschaltsignals auf.

Die Umschaltung mittels des externen Umschaltsignals, welches manuell oder automatisch erzeugt wird, erfolgt somit in Abhängigkeit der Überwachungsaufgabe und damit abhängig von dem Netzzustand des zu überwachenden Stromversorgungssystems.

Mit Vorteil ist die Auswerteinheit in dem ersten Betriebsmodus zur Prüfung einer Unterschreitung eines einstellbaren Isolationswiderstands-Grenzwertes und in dem zweiten Betriebsmodus zur Prüfung einer Überschreitung eines einstellbaren Schutzleiterwiderstands-Grenzwert ausgeführt.

Je nach Überwachungsaufgabe wird in der Auswerteeinheit ein einstellbarer Widerstands-Grenzwert als Isolationswiderstands-Grenzwert oder als Schutzleiterwiderstands-Grenzwert interpretiert und auf Unterschreitung oder Überschreitung durch den ermittelten Isolations- oder Schutzleiterwiderstand geprüft.

Weiterhin weist die kombinierte Überwachungsvorrichtung eine Schalteinrichtung auf, welche zur Trennung der aktiven Leiter des geerdeten Stromversorgungssystems vor die Ankopplungspunkte geschaltet ist, um im Fall eines in dem ungeerdeten Stromversorgungssystem festgestellten unzulässig niedrigen Isolationswiderstands die Aufschaltung des geerdeten Stromversorgungssystems zu verhindern.

Mit Vorteil weist die kombinierte Überwachungsvorrichtung gemäß einer zweiten Ausführungsform ein erstes Lastrelais auf, welches zur Trennung der aktiven Leiter des geerdeten Stromversorgungssystems vor die Ankopplungspunkte geschaltet ist - bezogen auf die durch die Ein- und Ausgänge der kombinierten Überwachungsvorrichtung bestimmte Richtung - und ein zweites Lastrelais, welches zur Trennung der aktiven Leiter des geerdeten Stromversorgungssystems hinter die Ankopplungspunkte geschaltet ist.

Das erste Lastrelais und das zweite Lastrelais ermöglichen eine wechselweise Aufschaltung des zu prüfenden Netzes an die kombinierte Überwachungsvorrichtung bei gleichzeitiger Trennung des jeweils anderen Netzes. Die Aufschaltung bzw. Trennung des zu prüfenden Netzes wird somit durch den Schaltzustand des ersten und zweiten Lastrelais bestimmt.

In weiterer vorteilhafter Ausgestaltung weist die kombinierte Überwachungsvorrichtung gemäß einer dritten Ausführungsform ein Lastrelais zur Trennung der aktiven Leiter des geerdeten Stromversorgungssystems sowie ein Umschaltrelais auf, welches über erste Ankopplungspunkte vor dem Lastrelais die aktiven Leiter zur Überwachung des geerdeten Stromversorgungssystems oder über zweite Ankopplungspunkte hinter dem Lastrelais die aktiven Leiter zur Überwachung des ungeerdeten Stromversorgungssystems mit der Ankopplungsschaltung verbindet.

Alternativ zu der Ausgestaltung der zweiten Ausführungsform mit zwei Lastrelais kann die Aufschaltung des zu prüfenden Netzes und die Trennung des jeweils anderen Netzes durch nur ein Lastrelais in Verbindung mit einem Umschaltrelais vorgenommen werden. Dazu ist das Umschaltrelais über erste/zweite Ankopplungspunkte vor/hinter dem Lastrelais mit den aktiven Leitern des ungeerdeten Stromversorgungssystems verbunden, um das betreffende Netz mit der Ankopplungsschaltung zu verbinden.

Gegenüber der Ausführung mit zwei Lastrelais erweist sich die Verwendung eines Umschaltrelais als eine hinsichtlich der Kosten und des Bauraumes nochmals günstigere Lösung, da das Lastrelais im Gegensatz zu dem Umschaltrelais den Laststrom schalten muss.

Bevorzugt weist die kombinierte Überwachungsvorrichtung eine Spannungsmesseinrichtung auf zur Messung einer Umschaltspannung oder mehrere Umschaltspannungen in dem geerdeten Stromversorgungssystem und zur automatischen Umschaltung der Auswerteeinheit - und damit auch der übergeordneten aktiven Überwachungseinrichtung - in den zweiten Betriebsmodus zur Überwachung des Schutzleiterwiderstands, falls die Umschaltspannung oder eine aus der Kombination mehrerer Umschaltspannungen abgeleitete Umschaltspannung einen einstellbaren Umschaltspannungs-Grenzwert überschreitet, und bei einer Unterschreitung des Umschaltspannungs-Grenzwertes wieder in den ersten Betriebsmodus zur Isolationsüberwachung umschaltet.

In Ergänzung der Umschaltmöglichkeit über den Umschaltsignal-Eingang mittels eines externen Umschaltsignals kann eine Umschaltung des Betriebsmodus auf den zweiten Betriebsmodus PE-Überwachung automatisch intern in der kombinierten Überwachungsvorrichtung erfolgen. Die Spannungsmesseinrichtung misst dazu mindestens eine Umschaltspannung in dem versorgenden, geerdeten Stromversorgungssystem. Überschreitet die gemessene Umschaltspannung oder eine aus der Kombination mehrerer Umschaltspannungen abgeleitete Umschaltspannung einen einstellbaren Umschaltspannungs-Grenzwert, kann davon ausgegangen werden, dass das geerdete Stromversorgungssystem mit seiner Netzspannung angeschlossen ist und die Spannungsmesseinrichtung veranlasst die Auswerteeinheit in den zweiten Betriebsmodus PE-Überwachung überzugehen. Bei einer unmittelbar darauffolgenden Unterschreitung des Umschaltspannungs-Grenzwertes schaltet die Auswerteeinheit vorzugsweise nach einer einstellbaren Verzögerungszeit (Hysterese) wieder auf den ersten Betriebsmodus Isolationsüberwachung um.

Die jeweilige gemessene Umschaltspannung ist eine Leiter-Leiter-Spannung über Messpunkte zwischen zwei beliebigen aktiven Leitern des geerdeten Stromversorgungssystems oder eine Leiter-Erde-Spannung über Messpunkte zwischen einem beliebigen aktiven Leiter und dem Schutzleiter des geerdeten Stromversorgungssystems.

Weitere vorteilhafte Ausgestaltungsmerkmale ergeben sich aus der nachfolgenden Beschreibung und den Zeichnungen, die bevorzugte Ausführungsformen der Erfindung an Hand von Beispielen erläutern. Es zeigen:
- **Fig. 1:**: ein Überwachungssystem zur Isolations- und Schutzleiterwiderstandsüberwachung nach dem Stand der Technik,
- **Fig. 2:**: eine erfindungsgemäße kombinierte Überwachungsvorrichtung in einer ersten Ausführungsform (Grundausführung),
- **Fig. 3:**: eine erfindungsgemäße kombinierte Überwachungsvorrichtung in einer zweiten Ausführungsform mit Spannungsmessung und zwei Lastrelais,
- **Fig. 4:**: eine erfindungsgemäße kombinierte Überwachungsvorrichtung in einer dritten Ausführungsform mit Spannungsmessung, einem Lastrelais und einem Umschaltrelais und
- **Fig. 5:**: eine Anwendung der erfindungsgemäßen kombinierten Überwachungsvorrichtung ausgehend von dem Stand der Technik.

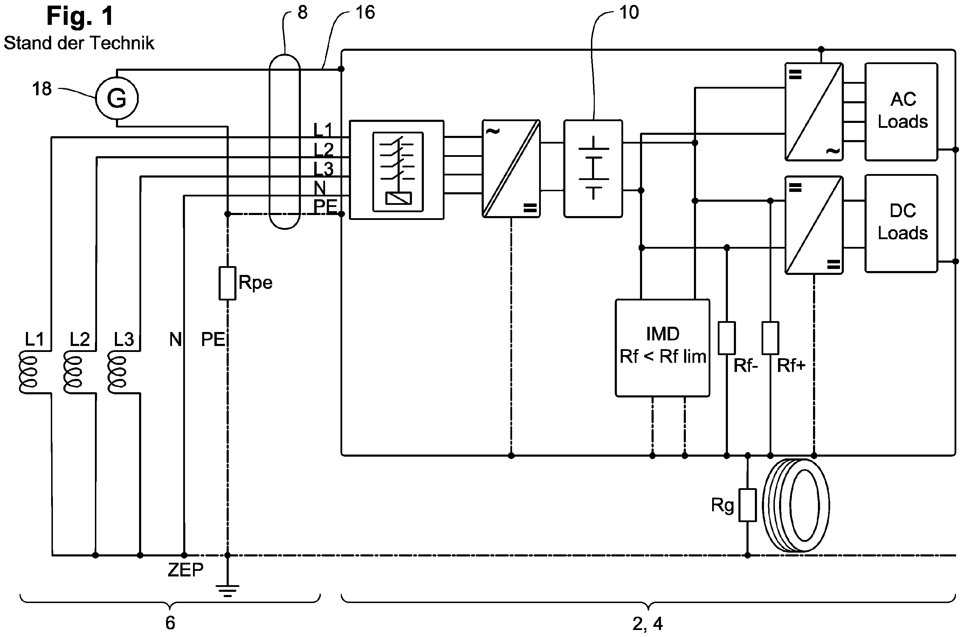

**Fig. 1** zeigt in einem funktionalen Blockdiagramm eine aus dem Stand der Technik bekannte Struktur eines Überwachungssystems zur Isolations- und Schutzleiterwiderstands-Überwachung.

Im geerdeten Netzzustand ist das ungeerdete Stromversorgungssystem 2 (ungeerdetes Netz) als Batterienetz 4 über ein Anschlusskabel 8 mit einem geerdeten Stromversorgungssystem 6 (geerdetes Netz) verbunden. Es ist ersichtlich, dass das Batterienetz 4 mit dem aufladbaren elektrischen Energiespeicher 10 (Batterie) durch diese Verbindung über einen zentralen Erdungspunkt ZEP geerdet und zu einem Verbraucher des geerdeten Stromversorgungssystems 6 wird. Ein Gehäusewiderstand Rg des Verbrauchergehäuses gegen Erde (zentraler Erdungspunkt ZEP) ist im Normalfall als hochohmig anzusehen.

Das geerdete Stromversorgungssystem 6 ist beispielhaft als versorgendes, dreiphasiges Netz mit den aktiven Leitern L1, L2, L3 und N und einem Schutzleiter PE (PE-Leiter) ausgeführt. Der Schutzleiter PE weist einen Schutzleiterwiderstand Rpe auf. Die Durchgängigkeit des Schutzleiters PE ist dabei sicherzustellen, der Schutzleiterwiderstand Rpe muss also hinreichend niederohmig sein.

Zur Schutzleiterüberwachung dient daher während des Betriebs im geerdeten Netzzustand ein zusätzlicher Signalkontakt 16, wie er beispielsweise im Bereich der Elektromobilität durch die Norm IEC 61851-1 vorgeschrieben ist. Über diesen Signalkontakt 16 wird von der versorgenden Infrastruktur - beispielsweise einer Ladestation des geerdeten Stromversorgungssystems 6 - ein definiertes Signal 18 zum versorgten Verbraucher - beispielsweise dem Elektrofahrzeug - gesendet und über den PE-Leiter PE zurückgeführt. Anhand des zurückgeführten Signals wird das Vorhandensein des PE-Leiters PE überprüft. Im Beispiel der Elektromobilität werden über diesen Signalkontakt und den PE-Leiter allerdings noch weitere Daten ausgetauscht. Als nachteilig erweist es sich, dass keine Aussage über die Güte des Schutzleiterwiderstandes Rpe getroffen wird, sondern nur das Vorhandensein des Schutzleiters PE ("PE ist da" oder "PE ist nicht da") festgestellt wird.

Die Isolationswiderstands-Überwachung während des Betriebs im ungeerdeten Netzzustand erfolgt über ein separat angeordnetes aktives Isolationsüberwachungsgerät 14 (IMD).

Somit sind dem Stand der Technik entsprechend zwei Geräte - eines für die Überwachung des Schutzleiterwiderstandes und eines für die Überwachung des Isolationswiderstandes - mit den daraus erwachsenen Nachteilen hinsichtlich Kosten, Energieverbrauch und Bauraum erforderlich.

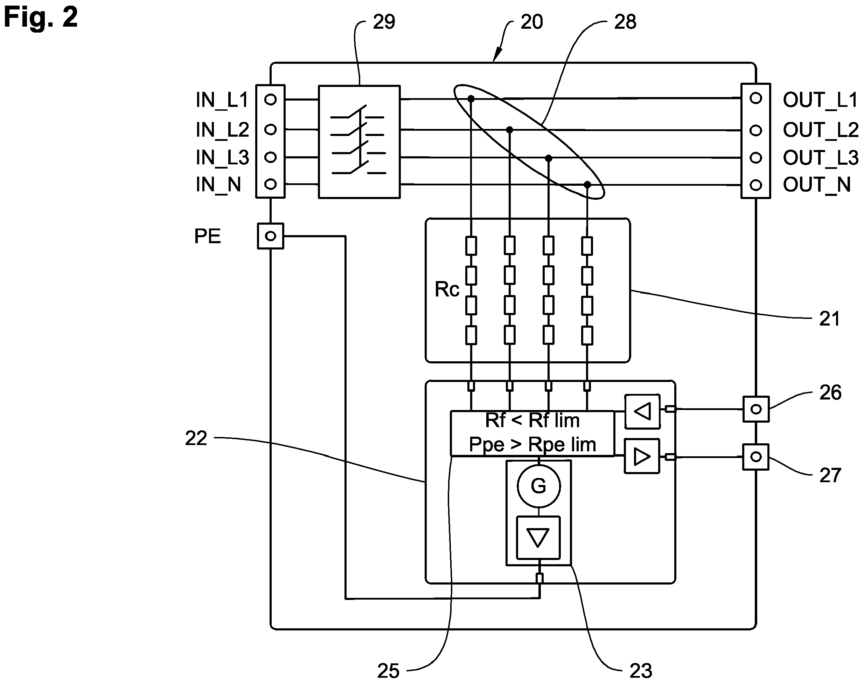

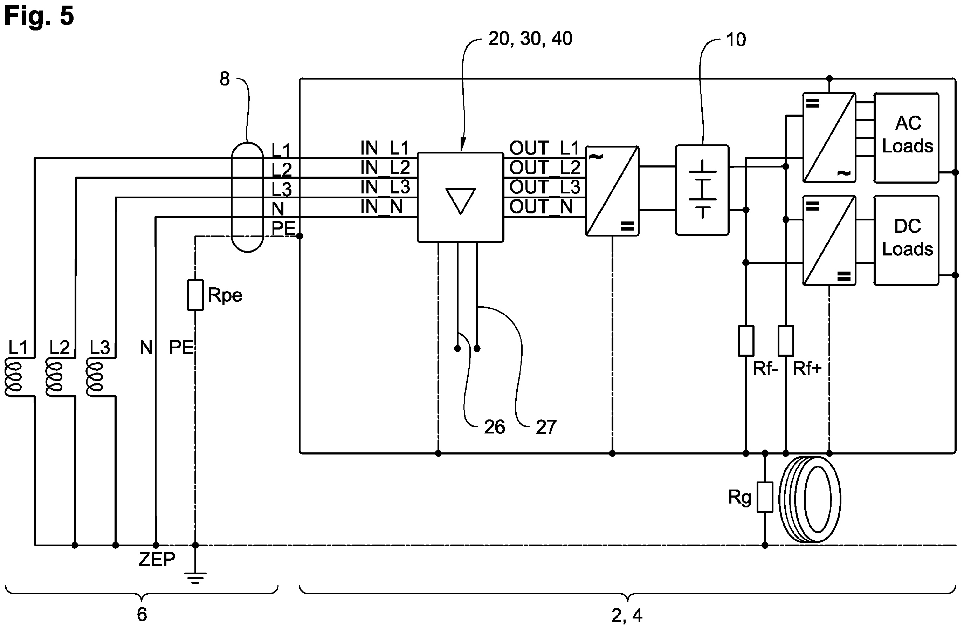

Die folgenden **Figuren 2 bis 4** zeigen in funktionalen Blockdiagrammen drei Ausführungsformen einer erfindungsgemäßen kombinierten Überwachungsvorrichtung 20, 30, 40, die gemäß Fig. 5 mit dem geerdeten Stromversorgungssystem 6 und dem ungeerdeten Stromversorgungssystem 2, 4 zusammenschaltbar ist.

Die beschriebenen kombinierten Überwachungsvorrichtungen 20, 30, 40 umfassen jeweils eine Ankopplungsschaltung 21 mit Ankopplungswiderständen Rc zur Ankopplung über Ankopplungspunkte 28 an die aktiven Leiter L1, L2, L3, N des geerdeten Stromversorgungssystems 6. Die kombinierten Überwachungsvorrichtungen 20, 30, 40 umfassen weiterhin jeweils eine aktive Überwachungseinrichtung 22, 32, 42, beruhen also auf einem aktiven Messverfahren, bei dem mittels einer symbolisch dargestellten Messspannungsquelle 23 eine Messspannung dem ungeerdeten Netz 2 überlagert wird und der resultierende Messstrom über einen Spannungsabfall an einem Messwiderstand innerhalb der aktiven Überwachungseinrichtung 22, 32, 42 zur Bestimmung des Isolationswiderstands Rf oder in erfindungsgemäß erweiterter Funktion zur Bestimmung des Schutzleiterwiderstands Rpe erfasst wird.

Die funktional dargestellte Ankopplungsschaltung 21 kann baulich auch Bestandteil der aktiven Überwachungseinrichtung 22, 32, 42 sein.

Die aktiven Überwachungseinrichtungen 22, 32, 42 weisen jeweils eine Auswerteeinheit 25 auf, die zwischen einem ersten Betriebsmodus zur Erkennung einer Unterschreitung eines Isolationswiderstands-Grenzwertes Rflim durch den ermittelten Isolationswiderstand Rf und einem zweiten Betriebsmodus zur Erkennung einer Überschreitung des Schutzleiterwiderstands-Grenzwertes Rpelim durch den ermittelten Schutzleiterwiderstand Rpe umschaltbar ausgeführt ist.

Die Unterschiede zwischen den beiden Betriebsmodi können anhand der folgenden Eigenschaften zusammengefasst werden:
- Isolationsüberwachungsmodus (für ungeerdetes Netz):
   - Hoher Widerstandswert (des ermittelten Isolationswiderstands) > Gut-Zustand
   - Niedriger Widerstandswert (des ermittelten Isolationswiderstands) > Schlecht-Zustand
   - Alarm > bei Unterschreiten des Isolationswiderstands-Grenzwertes Rflim
- PE-Überwachungsmodus (für geerdetes Netz):
   - Hoher Widerstandswert (des ermittelten Schutzleiterwiderstands) > Schlecht-Zustand
   - Niedriger Widerstandswert (des ermittelten Schutzleiterwiderstands) > Gut-Zustand
   - Alarmsignal > bei Überschreiten des Schutzleiterwiderstands-Grenzwertes Rpelim,
wobei die Grenze zwischen hohem und niedrigem Widerstandswert durch den jeweiligen Grenzwert Rflim, Rpelim anlagenspezifisch vorgegeben wird.

Zur Umschaltung des Betriebsmodus ist es also lediglich erforderlich, in Abhängigkeit der Netzform und der daraus resultierenden Überwachungsaufgabe die Entscheidungslogik der Auswerteeinheit 25 "umzukehren" und die Grenzwerte anzupassen.

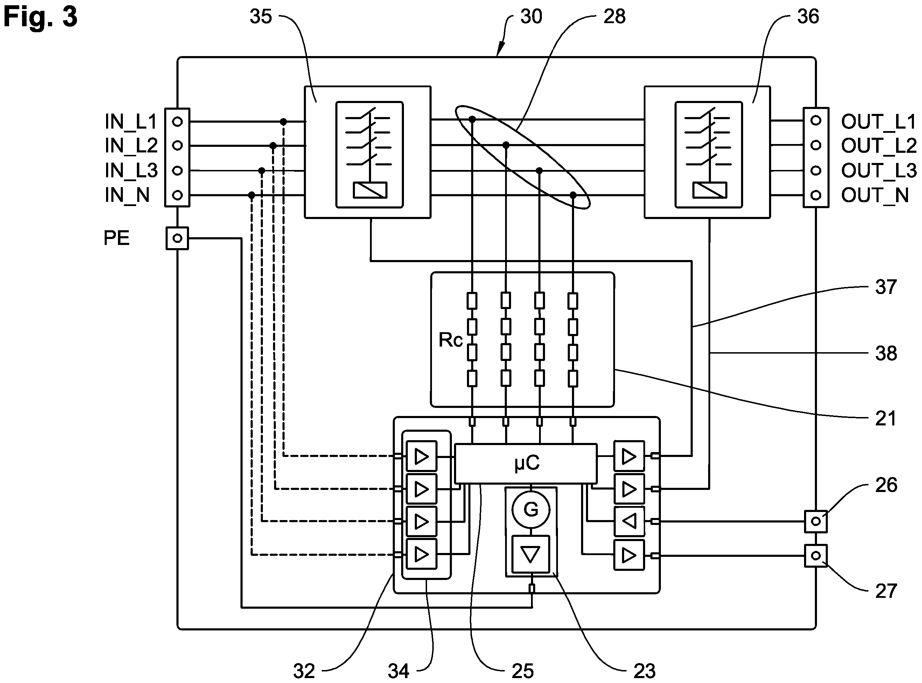

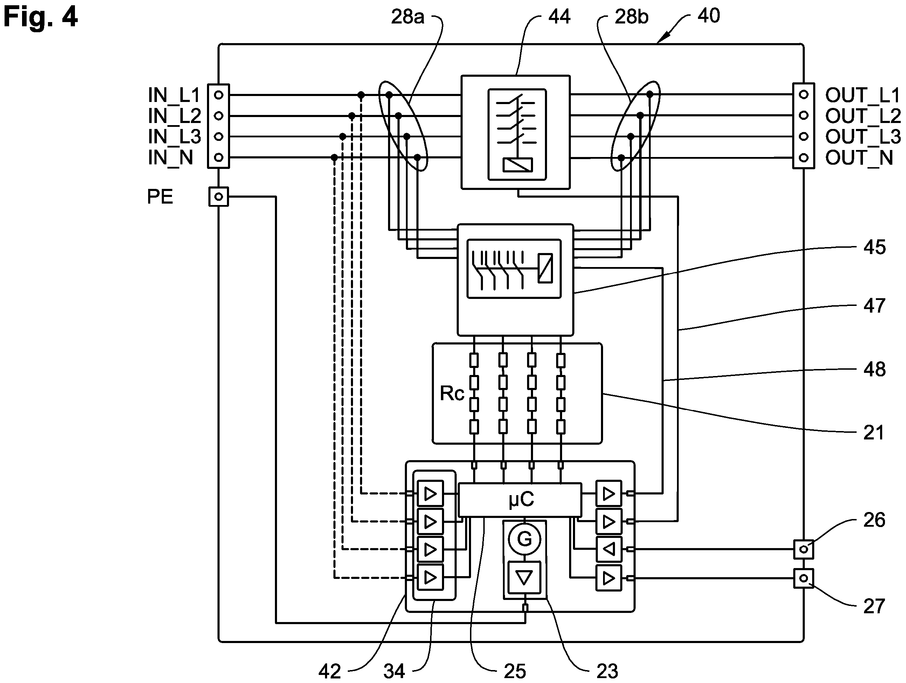

In allen drei Ausführungsformen der kombinierten Überwachungsvorrichtung 20, 30, 40 kann die Umschaltung des Betriebsmodus über einen Umschaltsignal-Eingang 26 der aktiven Überwachungseinrichtung 22, 32, 42 mittels eines externen Umschaltsignals erfolgen, in den Ausführungsformen 30, 40, wie in den Figuren 3 und 4 dargestellt, darüber hinaus auch automatisch durch eine Spannungsmesseinrichtung 34.

Zum Aussenden des Alarmsignals weist die Auswerteeinheit 25 mindestens einen Alarmsignal-Ausgang 27 auf. Der Alarmsignal-Ausgang 27 kann beispielsweise ein externes Relais schalten, um das Batterienetz 4 galvanisch vom angeschlossenen geerdeten Stromversorgungsnetz 6 zu trennen. Möglich sind auch mehrere Alarmsignal-Ausgänge 27, die sowohl analog als auch digital ausgeführt sein können und beispielsweise unterschiedliche Alarmstufen (Voralarm, Hauptalarm) repräsentieren.

In **Fig. 2** ist die erfindungsgemäße kombinierte Überwachungsvorrichtung 20 in einer ersten Ausführungsform schematisch dargestellt. Die hier dargestellte allpolige Ankopplung (Ankopplung an alle aktiven Leiter L1, L2, L3, N) über die Ankopplungswiderstände Rc ist beispielhaft. Grundsätzlich ist - wie auch für die weiteren Ausführungen der kombinierten Überwachungsvorrichtung 30, 40 in den Figuren 3 und 4 - auch eine einpolige Ankopplung ausreichend. Dabei ist es zur Messung des Schutzleiterwiderstandes irrelevant, ob sich die einpolige Ankopplung an einem Außenleiter L1, L2, L3 oder dem Neutralleiter N befindet. Zur Spannungsmessung und der damit verbundenen automatischen Umschaltung muss allerdings sichergestellt sein, dass die kombinierte Überwachungsvorrichtung 20 an einem Außenleiter L1, L2, L3 angekoppelt ist.

Die Umschaltung des Betriebsmodus erfolgt in dieser ersten Ausführungsform ausschließlich über den Umschaltsignal-Eingang 26 durch ein externes Umschaltsignal.

Zur Trennung der aktiven Leiter L1, L2, L3, N des geerdeten Stromversorgungssystems 6 ist vor die Ankopplungspunkte 28 eine Schalteinrichtung 29 geschaltet, um im Fall eines in dem ungeerdeten Stromversorgungssystem 2, 4 festgestellten unzulässig niedrigen Isolationswiderstands Rf die Aufschaltung des geerdeten Stromversorgungssystems 6 zu verhindern.

**Fig. 3** zeigt die erfindungsgemäße kombinierte Überwachungsvorrichtung 30 in einer zweiten Ausführungsform mit einer symbolisch dargestellten Spannungsmesseinrichtung 34, einem ersten Lastrelais 35 und einem zweiten Lastrelais 36.

Das erste Lastrelais 35 ist zur Trennung der aktiven Leiter des geerdeten Stromversorgungssystems 6, bezogen auf die durch die Ein- und Ausgänge der kombinierten Überwachungsvorrichtung 30 bestimmte Richtung, vor die Ankopplungspunkte 28 geschaltet. Das zweite Lastrelais 36 ist zur Trennung der aktiven Leiter des geerdeten Stromversorgungssystems 6 hinter die Ankopplungspunkte 28 geschaltet.

Die Umschaltung des Betriebsmodus erfolgt automatisch durch Spannungsmessung mittels der Spannungsmesseinrichtung 34, kann aber auch durch das externe Umschaltsignal wie in der ersten Ausführungsform ausgelöst werden.

Wird bei der Umschaltung durch Spannungsmessung zwischen zwei beliebigen Leitern L1, L2, L3, N eine Spannung gemessen, die einen einstellbaren Umschaltspannungs-Grenzwert überschreitet, öffnet das zweite Lastrelais 36 und das erste Lastrelais 35 schließt. Hierdurch wird das ungeerdete Netz 2 von der aktiven Überwachungseinrichtung 32 getrennt und die aktive Überwachungseinrichtung 32 wird über die Ankopplungsschaltung 21 an das geerdete Stromversorgungssystem 6 zur Schutzleiter-Überwachung angekoppelt. Die Auswerteeinheit 25 arbeitet in dem PE-Überwachungsmodus und ermittelt den Schutzleiterwiderstand Rpe. Liegt der Schutzleiterwiderstand Rpe unter einem zuvor definierten Schutzleiterwiderstands-Grenzwert und liegt der zuletzt vor dem Öffnen des zweiten Lastrelais 36 ermittelte Isolationswiderstand Rf oberhalb eines definierten Isolationswiderstands-Grenzwertes Rflim, schließt das zweite Lastrelais 36 wieder und das an den Anschlüssen OUT_x angeschlossene ungeerdete Stromversorgungssystem 2,4 wird somit geerdet.

Wird eine Spannung unterhalb des Umschaltspannungs-Grenzwertes gemessen, wird das erste Lastrelais 35 geöffnet und es wird wieder in den Isolationsüberwachungsmodus gewechselt, da davon ausgegangen werden kann, dass die Verbindung zum geerdeten Stromversorgungsnetz 6 unterbrochen wurde. Im Isolationsüberwachungsmodus wird bei Unterschreiten des Isolationswiderstands-Grenzwertes Rflim ein Alarmsignal über den Alarmsignal-Ausgang 27 gemeldet, um beispielsweise ein Abschalten der Batterie 10 (Fig. 5) zu bewirken.

Der Umschaltspannungs-Grenzwert ist grundsätzlich beliebig auf einen anlagenspezifischen, dem Schutzziel entsprechenden Schwellwert einstellbar und kann beispielsweise im Hinblick auf die Schutzmaßnahme Schutzkleinspannung 50 V betragen.

Im PE-Überwachungsmodus wird zusätzlich zu dem Aussenden des Alarmsignals noch das erste Lastrelais 35 geöffnet. Durch das Öffnen des ersten Lastrelais 35 liegt nun wieder ein ungeerdetes Netz 4 vor. Somit bietet die zweite Ausführungsform im Vergleich zu der ersten Ausführungsform den Vorteil, dass im Fehlerfall - bei Überschreiten des Schutzleiterwiderstands-Grenzwert (Rpelim) - die nachfolgende in dem Verbraucher angeordnete Leistungselektronik galvanisch vom Stromversorgungsnetz 6 getrennt wird.

Das erste/zweite Lastrelais 35/36 wird ausgehend von der Auswerteeinheit 25 mittels einer ersten/zweiten Steuersignalleitung 37/38 von der aktiven Überwachungseinrichtung 32 angesteuert.

**Fig. 4** zeigt die erfindungsgemäße kombinierte Überwachungsvorrichtung 40 in einer dritten Ausführungsform.

In dieser Ausführung arbeitet die kombinierte Überwachungsvorrichtung 40 nach dem gleichen Prinzip wie die zweite Ausführungsform, allerdings wird hierbei das zweite Lastrelais 36 (Fig. 3) eingespart und die wechselweise Aufschaltung des zu prüfenden Netzes (ungeerdet) 2, 4 oder (geerdet) 6 wird durch ein (zentrales) Lastrelais 44 in Verbindung mit einem Umschaltrelais 45 (engl. Coupling Changeover Relay) bewerkstelligt.

Dem jeweiligen Betriebsmodus entsprechend werden die Ankopplungswiderstände Rc der Ankopplungsschaltung 21 vor das Lastrelais 44, in der Darstellung linksseitig von dem Lastrelais 44 über erste Ankopplungspunkte (28a), zur PE-Überwachung oder hinter das Lastrelais 44 - in der Darstellung rechtsseitig von dem Lastrelais 44 über zweite Ankopplungspunkte (28b), zur Isolationsüberwachung angekoppelt. Die Meldung eines Alarmsignals erfolgt dabei analog zur zweiten Ausführungsform.

Der durch die Einsparung des zweiten Lastrelais 36 (Fig. 3) entstehende Vorteil hinsichtlich des Bauraums, der Verlustleistung und auch der Kosten wird besonders deutlich, wenn die Ankopplung der aktiven Überwachungseinrichtung 42 einpolig erfolgt.

Das Lastrelais 44/Umschaltrelais 45 werden ausgehend von der Auswerteeinheit 25 mittels einer Steuersignalleitung 47/Wechselsignalleitung 48 von der aktiven Überwachungseinrichtung 32 angesteuert.

In **Fig. 5** ist eine Anwendung der erfindungsgemäßen kombinierten Überwachungsvorrichtung 20, 30, 40 am Beispiel eines nicht galvanisch getrennten Verbrauchers mit integriertem aufladbarem elektrischen Energiespeicher 10 gezeigt, wobei die kombinierte Überwachungsvorrichtung 20, 30, 40 zur gemeinsamen Isolations- und Schleifenwiderstands-Überwachung in einer der drei Ausführungsformen 20, 30, 40 vorliegen kann und eingangsseitig über die Anschlüsse IN_L1, IN_L2, IN_L3; IN_N sowie ausgangsseitig über die Anschlüsse OUT_L1, OUT_L2, OUT_L3, OUT_N mit den aktiven Leitern L1, L2, L3, N verbunden ist.

Während des Betriebs im ungeerdeten Netzzustand - beispielsweise im Fahrbetriebs des Elektrofahrzeugs - wird der sich aus den Einzel-Isolationswiderständen Rf+ und Rf- gebildete Isolationswiderstand Rf des ungeerdeten Batterienetzes 4 bezogen auf ein leitfähiges Gehäuse des Verbrauchers - beispielsweise die Fahrzeugkarosserie - überwacht.

Im geerdeten Netzzustand - beispielsweise im Ladebetrieb des Elektrofahrzeugs - hingegen wird das ungeerdete Batterienetz 4 durch den galvanisch nicht getrennten Anschluss zu einem Verbraucher des in aller Regel geerdeten Stromversorgungsnetzes 6, sodass ein übergreifendes geerdetes Netz entsteht. Es handelt sich dabei um ein Betriebsmittel der Schutzklasse 1 gemäß IEC 60140. Das bedeutet, dass der Schutz gegen elektrischen Schlag durch die Verbindung des PE-Leiters PE - also in diesem Fall des leitfähigen Gehäuses des Verbrauchers - mit dem geerdeten Schutzpotential des geerdeten Versorgungsnetzes 6 sichergestellt werden muss. Hierbei ist der Zustand des Schutzleiters PE - also dessen Niederohmigkeit - maßgeblich für die Wirksamkeit der Schutzmaßnahme.

Durch die erfindungsgemäße kombinierte Überwachungsvorrichtung kann die niederohmige Verbindung zum Erdpotential (zentraler Erdungspunkt ZEP) ohne einen zusätzlichen Hilfsleiter festgestellt und darüber hinaus - beispielsweise im Vergleich zur Elektromobilität - der tatsächliche Widerstandswert des Schutzleiterwiderstands Rpe bestimmt werden, indem im geerdeten Betrieb der Schleifenwiderstand von L1, L2, L3 und N (je nach Art und Anzahl der aktiven Leiter L1, L2, L3, N des versorgenden geerdeten Stromversorgungssystems 6 und Art der Ankopplung) über den Schutzleiterwiderstand Rpe zurück zum Fahrzeug gemessen wird.

## Patentansprüche

1. Kombinierte Überwachungsvorrichtung (20, 30, 40) zur Isolationswiderstands- und Schutzleiterwiderstands-Überwachung in einem Stromversorgungssystem, welches ein geerdetes Stromversorgungssystem (6) und ein ungeerdetes Stromversorgungssystem (2, 4) umfasst,
mit einer Ankopplungsschaltung (21) zur Ankopplung an einen oder mehrere aktive Leiter (L1, L2, L3, N) des geerdeten Stromversorgungssystems (6) über Ankopplungspunkte (28),
mit genau einer über die Ankopplungsschaltung (21) angekoppelten aktiven Überwachungseinrichtung (22, 32, 42), welche einen ersten Betriebsmodus zur Überwachung eines Isolationswiderstands (Rf) in einem ungeerdeten Netzzustand des Stromversorgungssystems (2, 4, 6) und einen zweiten Betriebsmodus zur Überwachung eines Schutzleiterwiderstands (Rpe) in einem geerdeten Netzzustand des Stromversorgungssystems (2, 4, 6) aufweist, und
eine in Abhängigkeit des ungeerdeten oder geerdeten Netzzustands zwischen dem ersten Betriebsmodus und dem zweiten Betriebsmodus umschaltbare Auswerteeinheit (25) aufweist, die in dem ersten Betriebsmodus zur Prüfung des Isolationswiderstands (Rf) und in dem zweiten Betriebsmodus zur Prüfung des Schutzleiterwiderstands (Rpe) ausgeführt ist.

2. Kombinierte Überwachungsvorrichtung (20, 30, 40) nach Anspruch 1, **dadurch gekennzeichnet, dass** die aktive Überwachungseinrichtung (22, 32, 42) einen Umschaltsignal-Eingang (26) zur Umschaltung zwischen dem ersten Betriebsmodus und dem zweiten Betriebsmodus mittels eines externen Umschaltsignals aufweist.

3. Kombinierte Überwachungsvorrichtung (20, 30, 40) nach Anspruch 1 oder 2,
**dadurch gekennzeichnet,**
**dass** die Auswerteeinheit (25) in dem ersten Betriebsmodus zur Prüfung einer Unterschreitung eines einstellbaren Isolationswiderstands-Grenzwertes (Rflim) und in dem zweiten Betriebsmodus zur Prüfung einer Überschreitung eines einstellbaren Schutzleiterwiderstands-Grenzwert (Rpelim) ausgeführt ist.

4. Kombinierte Überwachungsvorrichtung (20) nach einem der Ansprüche 1 bis 3,
**gekennzeichnet durch**
eine Schalteinrichtung (29), welche zur Trennung der aktiven Leiter (L1, L2, L3, N) des geerdeten Stromversorgungssystems (6) vor die Ankopplungspunkte (28) geschaltet ist, um im Fall eines in dem ungeerdeten Stromversorgungssystem (2, 4) festgestellten unzulässig niedrigen Isolationswiderstands (Rf) die Aufschaltung des geerdeten Stromversorgungssystems (6) zu verhindern.

5. Kombinierte Überwachungsvorrichtung (30) nach einem der Ansprüche 1 bis 3,
**gekennzeichnet durch**
ein erstes Lastrelais (35), welches zur Trennung der aktiven Leiter (L1, L2, L3, N) vor die Ankopplungspunkte (28) geschaltet ist und ein zweites Lastrelais (36), welches zur Trennung der aktiven Leiter (L1, L2, L3, N) hinter die Ankopplungspunkte (28) geschaltet ist.

6. Kombinierte Überwachungsvorrichtung (40) nach einem der Ansprüche 1 bis 3,
**gekennzeichnet durch**
ein Lastrelais (44) zur Trennung der aktiven Leiter (L1, L2, L3, N) und ein Umschaltrelais (45), welches über erste Ankopplungspunkte (28a) vor dem Lastrelais (44) die aktiven Leiter (L1, L2, L3, N) zur Überwachung des geerdeten Stromversorgungssystems (6) oder über zweite Ankopplungspunkte (28b) hinter dem Lastrelais (44) die aktiven Leiter (L1, L2, L3, N) zur Überwachung des ungeerdeten Stromversorgungssystems (2, 4) mit der Ankopplungsschaltung (21) verbindet.

7. Kombinierte Überwachungsvorrichtung (30, 40) nach Anspruch 5 oder 6,
**gekennzeichnet durch**
eine Spannungsmesseinrichtung (34) zur Messung einer Umschaltspannung oder mehrerer Umschaltspannungen in dem geerdeten Stromversorgungssystem (6) und zur automatischen Umschaltung der Auswerteeinheit (25) in den zweiten Betriebsmodus zur Überwachung des Schutzleiterwiderstands (Rpe), falls die Umschaltspannung oder eine aus der Kombination mehrerer Umschaltspannungen abgeleitete Umschaltspannung einen einstellbaren Umschaltspannungs-Grenzwert überschreitet, und bei einer Unterschreitung des Umschaltspannungs-Grenzwertes wieder in den ersten Betriebsmodus zur Isolationsüberwachung umschaltet.

8. Kombinierte Überwachungsvorrichtung (30, 40) nach Anspruch 7, **dadurch gekennzeichnet,**
**dass** die jeweilige gemessene Umschaltspannung eine Leiter-Leiter-Spannung über Messpunkte zwischen zwei beliebigen aktiven Leitern (L1, L2, L3, N) des geerdeten Stromversorgungssystems (6) oder eine Leiter-Erde-Spannung über Messpunkte zwischen einem beliebigen aktiven Leiter (L1, L2, L3, N) und dem Schutzleiter (PE) des geerdeten Stromversorgungssystems (6) ist.

## Claims

1. A combined monitoring device (20, 30, 40) for insulation-resistance monitoring and protective-conductor-resistance monitoring in a power supply system which comprises a grounded power supply system (6) and an ungrounded power supply system (2, 4), the combined monitoring device (20, 30, 40),
comprising a coupling circuit (21) for being coupled to one or several active conductors (L 1, L2, L3, N) of the grounded power supply system (6) via coupling points (28),
comprising precisely one active monitoring device (22, 32, 42) which is coupled via the coupling circuit (21) and comprises a first operating mode for monitoring an insulation resistance (Rf) in an ungrounded network state of the power supply system (2, 4, 6) and a second operating mode for monitoring a protective-conductor resistance (Rpe) in a grounded network state of the power supply system (2, 4, 6), and
comprising an evaluation unit (25) which is switchable between the first operating mode and the second operating mode as a function of the ungrounded or grounded network state and is configured for testing the insulation resistance (Rf) in the first operating mode and for testing the protective-conductor resistance (Rpe) in the second operating mode.

2. The combined monitoring device (20, 30, 40) according to claim 1, **characterized in that**
the active monitoring device (22, 32, 42) comprises a switch-signal input (26) for switching between the first operating mode and the second operating mode by means of an external switch signal.

3. The combined monitoring device (20, 30, 40) according to claim 1 or 2,
**characterized in that**
the evaluation unit (25) is configured for testing in the first operating mode whether a settable insulation-resistance threshold (Rflim) has been undershot and for testing in the second operating mode whether a settable protective-conductor-resistance threshold (Rpelim) has been exceeded.

4. The combined monitoring device (20) according to any of the claims 1 to 3,
**characterized by**
a switch device (29) which is connected upstream of the coupling points (28) for disconnecting the active conductors (L1, L2, L3, N) of the grounded power supply system (6) so as to prevent the grounded power supply system (6) from being operated in the event that an impermissibly low insulation resistance (Rf) is determined in the ungrounded power supply system (2, 4).

5. The combined monitoring device (30) according to any of the claims 1 to 3,
**characterized by**
a first load relay (35) which is connected upstream of the coupling points (28) for disconnecting the active conductors (L1, L2, L3, N), and a second load relay (36) which is connected downstream of the coupling points (28) for disconnecting the active conductors (L1, L2, L3, N).

6. The combined monitoring device (40) according to any of the claims 1 to 3,
**characterized by**
a load relay (44) for disconnecting the active conductors (L1, L2, L3, N), and a changeover relay (45) which connects the active conductors (L1, L2, L3, N) to the coupling circuit (21) upstream of the load relay (44) via first coupling points (28a) so as to monitor the grounded power supply system (6) or connects the active conductors (L1, L2, L3, N) to the coupling circuit (21) downstream of the load relay (44) via second coupling points (28b) so as to monitor the ungrounded power supply system (2, 4).

7. The combined monitoring device (30, 40) according to claim 5 or 6,
**characterized by**
a voltage-measuring device (34) for measuring one changeover voltage or several changeover voltages in the grounded power supply system (6) and for automatically switching the evaluation unit (25) to the second operating mode so as to monitor the protective-conductor resistance (Rpe) if the changeover voltage or a changeover voltage which has been derived from the combination of several changeover voltages exceeds a settable changeover-voltage threshold and switches back to the first operating mode for insulation monitoring when the changeover-voltage threshold is undershot.

8. The combined monitoring device (30, 40) according to claim 7, **characterized in that**
the corresponding measured changeover voltage is a conductor-conductor voltage via measuring points between two arbitrary active conductors (L1, L2, L3, N) of the grounded power supply system (6) or a conductor-ground voltage via measuring points between an arbitrary active conductor (L 1, L2, L3, N) and the protective conductor (PE) of the grounded power supply system (6).

## Revendications

1. Dispositif de surveillance (20, 30, 40) combiné pour la surveillance d'une résistance d'isolement et pour la surveillance d'une résistance de conducteur de protection dans un système d'alimentation en énergie qui comprend un système (6) d'alimentation en énergie mis à la terre et un système (2, 4) d'alimentation en énergie non mis à la terre, le dispositif de surveillance (20, 30, 40) combiné
comprenant un circuit de couplage (21) pour le couplage à un ou plusieurs conducteurs (L1, L2, L3, N) actifs du système (6) d'alimentation en énergie mis à la terre par des points de couplage (28),
comprenant exactement un dispositif de surveillance (22, 32, 42) actif qui est couplé par le circuit de couplage (21) et comprend un premier mode d'opération pour la surveillance d'un résistance d'isolement (Rf) dans un état de réseau non mis à la terre du système (2, 4, 6) d'alimentation en énergie et un deuxième mode d'opération pour la surveillance d'une résistance (Rpe) du conducteur de protection dans un état de réseau mis à la terre du système (2, 4, 6) d'alimentation en énergie, et
comprenant une unité d'évaluation (25) qui peut être commutée entre le premier mode d'opération et le deuxième mode d'opération en fonction de l'état de réseau non mis à la terre ou mis à la terre et qui est configurée pour l'essai de la résistance d'isolement (Rf) dans le premier mode d'opération et pour l'essai de la résistance (Rpe) du conducteur de protection dans le deuxième mode d'opération.

2. Dispositif de surveillance (20, 30, 40) combiné selon la revendication 1,
**caractérisé en ce que**
le dispositif de surveillance (22, 32, 42) actif comprend une entrée (26) de signal de commutation pour la commutation entre le premier mode d'opération et le deuxième mode d'opération au moyen d'un signal de commutation extérieur.

3. Dispositif de surveillance (20, 30, 40) combiné selon la revendication 1 ou la revendication 2,
**caractérisé en ce que**
l'unité d'évaluation (25) est configurée pour l'essai dans le premier mode d'opération afin de déterminer une non-atteinte d'un seuil (Rflim) réglable d'une résistance d'isolement et pour l'essai dans le deuxième mode d'opération afin de déterminer un dépassement d'un seuil (Rpelim) réglable d'une résistance de conducteur de protection.

4. Dispositif de surveillance (20) combiné selon l'une quelconque des revendications 1 à 3,
**caractérisé par**
un dispositif de commutation (29) qui est connecté en amont des points de couplage (28) pour la déconnexion des conducteurs (L1, L2, L3, N) actifs du système (6) d'alimentation en énergie mis à la terre afin d'empêcher une opération du système (6) d'alimentation en énergie mis à la terre dans l'éventualité où une résistance d'isolement (Rf) inadmissiblement bas est déterminée dans le système (2, 4) d'alimentation en énergie non mis à la terre.

5. Dispositif de surveillance (30) combiné selon l'une quelconque des revendications 1 à 3,
**caractérisé par**
un premier relais de charge (35) qui est connecté en amont des points de couplage (28) pour la déconnexion des conducteurs (L1, L2, L3, N) actifs, et un deuxième relais de charge (36) qui est connecté en aval des points de couplage (28) pour la déconnexion des conducteurs (L1, L2, L3, N) actifs.

6. Dispositif de surveillance (40) combiné selon l'une quelconque des revendications 1 à 3,
**caractérisé par**
un relais de charge (44) pour la déconnexion des conducteurs (L1, L2, L3, N) actifs, et un relais de commutation (45) qui connecte les conducteurs (L1, L2, L3, N) actifs au circuit de couplage (21) en amont du relais de charge (44) par le premiers points de couplage (28a) pour la surveillance du système (6) d'alimentation en énergie mis à la terre ou qui connecte les conducteurs (L1, L2, L3, N) actifs au circuit de couplage (21) en aval du relais de charge (44) par les deuxièmes points de couplage (28b) pour la surveillance du système (2, 4) d'alimentation en énergie non mis à la terre.

7. Dispositif de surveillance (30, 40) combiné selon la revendication 5 ou la revendication 6,
**caractérisé par**
un dispositif (34) de mesure de voltage pour la mesure d'une tension de commutation ou de plusieurs tensions de commutation dans le système (6) d'alimentation en énergie mis à la terre et pour la commutation automatique de l'unité d'évaluation (25) au deuxième mode d'opération pour la surveillance de la résistance (Rpe) du conducteur de protection si la tension de commutation ou une tension de commutation qui a été dérivée par la combinaison de plusieurs tensions de commutation dépasse un seuil réglable de la tension de commutation et commute au premier mode d'opération pour la surveillance d'isolement si le seuil d'une tension de commutation n'est pas atteint.

8. Dispositif de surveillance (30, 40) combiné selon la revendication 7,
**caractérisé en ce que**
la tension de commutation mesurée correspondante est une tension conducteur-conducteur par les points de mesure entre deux quelconques conducteurs (L1, L2, L3, N) actifs du système (6) d'alimentation en énergie mis à la terre ou est une tension conducteur-terre par les points de mesure entre un quelconque conducteur (L1, L2, L3, N) actif et un conducteur de protection (PE) du système (6) d'alimentation en énergie mis à la terre.
